# EUROPÄISCHE PATENTSCHRIFT

(11) **EP 0 612 435 B1**
(45) Veröffentlichungstag und Bekanntmachung des Hinweises auf die Patenterteilung: **28.06.1995**
(21) Anmeldenummer: 92922939.1
(22) Anmeldetag: 06.11.1992
(51) Int. Cl.: H01B 13/00

(54) **KABELBAUM-LEGEVORRICHTUNG**
CABLE HARNESS LAYING DEVICE
DISPOSITIF DE POSE DE FAISCEAUX DE CABLES

(30) Priorität: 15.11.1991 DE 9114276 U
(43) Veröffentlichungstag der Anmeldung: 31.08.1994
(73) Patentinhaber: Paul Hellermann GmbH, 25421 Pinneberg (DE)
(72) Erfinder: KURMIS, Victor, D-2080 Pinneberg (DE)
(74) Vertreter: Glawe, Delfs, Moll & Partner
(86) Internationale Anmeldenummer: EP9202542
(87) Internationale Veröffentlichungsnummer: WO9310541

(56) Entgegenhaltungen:
- GB-A- 2 246 087
- US-A- 4 337 934
- US-A- 4 566 502
- IBM TECHNICAL DISCLOSURE BULLETIN. Bd. 28, Nr. 12, Mai 1986, NEW YORK US Seiten
- 5607 - 5610 'Self-storing build board system for automated harness-cableassembly'

## Beschreibung

In elektrischen Anlagen mit vielen Verbindungskabeln ist es üblich, diese Kabel zu sogenannten Kabelbäumen zusammenzufassen und diese zwecks leichterer Montage vorzufertigen. Für die Vorfertigung bedient man sich einer Legevorrichtung, die auf einem tischartigen, sogenannten Legebrett eine Mehrzahl von oben offenen Halterungen aufweist, in die die Kabel eingelegt werden und von denen der Kabelbaum insbesondere bei Abzweigungen und Biegungen in der vorbestimmten Lage gehalten wird. Sind sämtliche Einzelkabel zum Kabelbaum in der Vorrichtung zusammengetragen, wird der Kabelbaum an mehreren Stellen mit Kabelbindern abgebunden, und der Legevorrichtung entnommen.

Bekannte Legevorrichtungen weisen U-förmige Halter auf, die von zwei an einer gemeinsamen Stütze befestigten Haltefingern gebildet sind, wobei das obere Ende der Stütze am Grunde der beiden Haltefinger eine Unterstützung für den Kabelbaum bildet, die von dem Legebrett abgehoben ist, damit ein für den Eingriff eines Bindewerkzeugs notwendiger Abstand zwischen dem Kabelbaum und dem Kabelbrett verbleibt. An denjenigen Stellen, wo der Kabelbaum seine Verlegungsrichtung ändert, werden Halter verwendet, deren U-Öffnung seitlich gerichtet ist, wobei der obere der in diesem Fall horizontal angeordneten Haltefinger nach oben ausklappbar ist, um die Herausnahme des Kabelbaums zu vereinfachen. Wieder andere Halter haben die Form einfacher Nägel oder Stifte, die in das Legebrett eingeschlagen werden und gleichfalls zur seitlichen Begrenzung der Kabelbaumlage dienen. (Quelle dieses Standes der Technik: Prospekte der Firmen Panduit Corp. und Thomas & Betts).

Zum Abbinden von Kabelbäumen mittels Kabelbindern verwendet man Abbindewerkzeuge, die einen armdicken Werkzeugkörper und an dessen vorderem Ende einen den Kabelbaum zangenartig umfassenden, schmalen Führungsteil umfassen. Die Kabelbinder werden gerne so nahe als möglich an Abzweigungen oder Biegungen des Kabelbaums gesetzt. Das sind aber auch gerade diejenigen Stellen, an denen sich in der Legevorrichtung in der Regel ein Halter oder Haltefinger befindet. Man will deshalb den Kabelbinder so nahe als möglich an einem solchen Halter oder Haltefinger setzen. Dabei erweist sich oft die Breite des Werkzeugkörpers als hinderlich, weil sie es unmöglich macht, den schmalen Führungsteil unmittelbar neben einem Halter anzusetzen. Für den Biegebereich eines Kabelbaums schlägt deshalb die US-A-4 337 934 einen Haltefinger vor, der an einem in das Legebrett eingeschlagenen Haltestift in seiner Längsrichtung verschiebbar ist und an seinem unteren Ende einen Teller trägt, der zur Unterstützung des Kabelbaums dient. Sobald der Kabelbaum fertig geformt ist und abgebunden werden soll, wird der Finger samt Teller an dem Haltestift abgesenkt, so daß der Kabelbaum in diesem Bereich nun frei liegt und einem Abbindewerkzeug zugänglich ist. Diese bekannte Lösung hat den Nachteil, daß die Unterstützung des Kabelbaums und seine seitliche Eingrenzung bei der Absenkung des Haltefingers wegfällt. Sie setzt deshalb voraus, daß der Kabelbaum in der Nachbarschaft der Biegung starr gehalten ist, nämlich durch vertikal unnachgiebige Halter, an denen je ein Paar quer zum Kabelbaum federnd nachgiebiger Klammern angeordnet sind, deren Nachgiebigkeit so bemessen ist, daß Drähte zum Bilden des Kabelbaums zwischen sie eingeführt und der fertige Kabelbaum zwischen ihnen herausgenommen werden kann (US-A-4 029 277). Die Nachgiebigkeit reicht aber nicht aus, um den Kabelbaum für ein Abbindewerkzeug frei zugänglich zu machen. Offensichtlich hielt man dies im Bereich des geraden Kabelbaumverlaufs nicht für erforderlich , weil man meinte, daß dort ohnehin hinreichender Platz zum Anbringen der Abbindestelle oder zur Anordnung einer Stütze vorhanden sind. Jedoch übersieht dies die Bedeutung von Abzweigungen, die aus dem geraden Verlauf des Kabelbaums ausgehen können und bei denen man sowohl gern eine Stütze als auch ein Abbindestelle vorsieht.

Der Erfindung liegt daher die Aufgabe zugrunde, eine Kabelbaumlegevorrichtung gemäß dem Gattungsbegriff des Anspruchs 1 zu schaffen, die dem Kabelbaum eine gute und auch während des Abbindevorgangs verbleibende Unterstützung gewährt und dennoch dem Abbindewerkzeug weitgehend freien Zugang ermöglicht. Sie geht aus von der US-A-4337934.

Die erfindungsgemäße Lösung liegt in den Merkmalen des Anspruchs 1 sowie vorzugsweise in denen des Unteranspruches.

Dadurch, daß ein Halter verwendet wird, dessen Haltefinger in einer etwa quer zur Kabelbaumlängsrichtung verlaufenden Richtung ausweichfähig ist und durch Federkraft in die Ausgangsstellung zurückgeführt wird, ist es möglich, das Werkzeug dem Haltefinger so zu nähern, daß er aus seiner Lage verdrängt wird und dadurch dem Werkzeug die Möglichkeit gibt, Stellen zu erreichen, die ihm anderenfalls verwehrt sein würden. Da die Stütze des Kabelbaums nicht mit dem ausweichenden Haltefinder verbunden ist, sondern während der normalen Benutzung feststeht, bleibt die Kabelbaumunterstützung in der Vertikalrichtung auch dann erhalten, wenn ein herangeführtes Abbindewerkzeug den Haltefinger zum Ausweichen zwingt.

Der Haltefinger ist in seiner Längsrichtung an oder in einer der Stützen verschiebbar, an der er angebracht ist. Insbesondere kann die Stütze rohrförmig ausgeführt sein, wobei der Haltefinger teleskopisch in die Stütze einschiebbar ist. Dies geschieht gegen Federkraft, die den Haltefinger in seine Ausgangslage zurückführt, sobald die ihn verdrängende Kraft endet. Die Ausweichbewegung des Haltefingers in seiner eigenen Richtung, d.h. nach unten zum Legebrett hin, ist deshalb besonders vorteilhaft, weil die Bindewerkzeuge in der Regel oberhalb des Legebretts aufgehängt sind und daher von oben an den Kabelbaum herangeführt werden.

Der Begriff Haltefinger soll im Zusammenhang der Erfindung sämtliche Einrichtungen umfassen, die zur seitlichen Eingrenzung der Kabelbaumlage verwendet werden. Bei paariger Anordnung der Haltefinger wird die Kabelbaumunterstützung von einer Brücke gebildet, die die jeweils gesondert am Legebrett befestigten Stützen miteinander verbindet.

Die Erfindung wird im folgenden näher unter Bezugnahme auf das in der Zeichnung dargestellte Ausführungsbeispiel veranschaulicht. Es zeigen:
- Fig. 1: eine Draufsicht auf eine Legevorrichtung,
- Fig. 2: eine Seitenansicht von zwei paarig angeordneten Haltefingern und
- Fig. 3: die Teilansicht eines Kabelbaums in der Legevorrichtung im Abbindevorgang

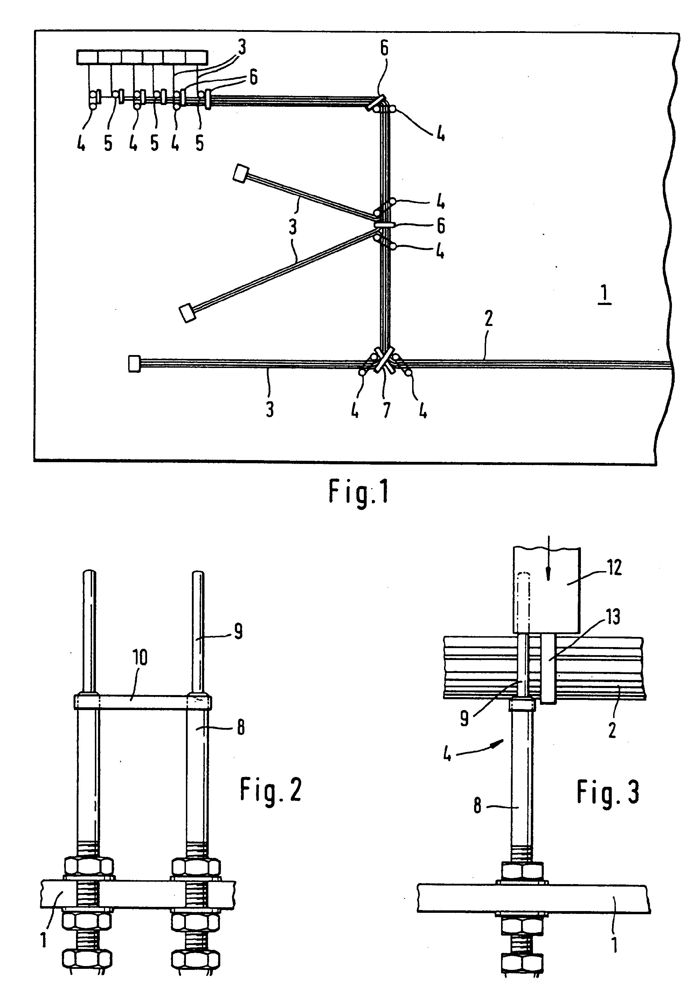

Auf dem Legebrett 1, das horizontal tischartig angeordnet sein kann aber nicht muß, ist der Kabelbaum 2 mit seinen Abzweigungen 3 zu legen. Um die Kabel in der vorgesehenen Lage vorläufig zu sichern, sind Halter 4 vorgesehen, die jeweils zwei Haltefinger beiderseits des Kabelbaums umfassen. Außerdem sind bei 5 einzelne Haltefinger im Bereich von Abzweigungen vorgesehen. Man erkennt, daß die Halter vornehmlich dort eingesetzt werden, wo Umlenkungen und Abzweigungen stattfinden. Ferner ist aus Fig. 1 ersichtlich, an welchen Stellen Kabelbinder 6 zu setzen sind, nämlich jeweils bei den Abzweigungen, wobei sie teilweise auch als Kreuzbinder 7 doppelt angeordnet werden.

Sowohl die Halter als auch die Binder können ihre Funktion nur dann optimal entfalten, wenn sie jeweils in die Ecken der Abbiegungen und Abzweigungen hineinwirken. Die Binder befinden sich daher ideal an derselben Stelle wie die Halter, praktisch im geringstmöglichen Abstand von diesen.

Um das Ansetzen des Bindewerkzeugs in unmittelbarer Nähe der Halter zu ermöglichen, haben die Halter den aus Fig. 2 ersichtlichen Aufbau. Sie bestehen aus einer Stütze 8, die in geeigneter Weise an dem Legebrett 1 befestigt werden kann, und dem Haltefinger 9, der teleskopisch in der rohrförmigen Stütze 8 geführt ist und gegen Federkraft in sie einschiebbar ist.

Die Halter können zu Paaren zusammengesetzt werden, wie dies in Fig. 2 dargestellt ist. Zwar werden sie gesondert am Legebrett befestigt; jedoch werden sie nahe dem oberen Ende der Stützen 8 durch eine Brücke 10 verbunden, die sie auf der für die jeweilige Dicke des Kabelbaums richtigen Distanz hält und außerdem eine Unterstützung für den Kabelbaum in Abstand vom Legebrett 1 bildet. Brücken 10 werden in unterschiedlichen Längen vorrätig gehalten, um unterschiedlichen Kabelbaumdicken Rechnung tragen zu können. So läßt sich mit nur einem Typ von Haltern bzw. Haltefingern und einer Mehrzahl von Brücken jede in der Praxis benötigte Variante von nach oben offenen Haltern verwirklichen.

Fig. 3 zeigt einen Kabelbaum 2 und einen Halter 4, bestehend aus Stütze 8 und Haltefinger 9, in Seitenansicht. Will man unmittelbar daneben eine Abbindung vollziehen, so führt man das Werkzeug 12 von oben her heran, wobei die schmale, den Kabelbaum 2 zangenartig umfassende Bandführung 13 an der Bindestelle unmittelbar neben dem Halter 4 zu plazieren ist.

Dies wäre unmöglich, wenn der Haltefinger 9 seine strichpunktiert angedeutete Ausgangsstellung beibehalten würde. Da er jedoch teleskopisch in die Stütze 8 einschiebbar ist, kann er durch das von oben herangeführte Werkzeug 12 verdrängt werden und bildet daher kein Hindernis für die Abbindung unmittelbar neben dem Halter 4. Dabei behält die Kabelbaumunterstützung 10 ihre Lage bei. Daher ist nicht zu befürchten, daß der Kabelbaum sich im Abbindebereich vertikal (quer zum Legebrett) verformt. Außerdem bleibt der Kabelbaum seitlich durch die Haltefinger 9 eingegrenzt, weil diese nur insoweit verdrängt werden, als das Werkzeug herangeführt wird. Somit sind sie ausweichfähig, ohne ihre Führungsfunktion zu verlieren.

## Patentansprüche

1. Kabelbaum-Legevorrichtung mit wenigstens einem auf einem Legebrett (1) befestigbaren Halter (4), dessen die Kabelbaumlage seitlich begrenzende Haltefinger (9) quer zur Kabelbaumlängsrichtung ausweichfähig sind, dadurch gekennzeichnet, daß der Halter (4) von mindestens zwei am Legebrett (1) befestigten und untereinander durch eine Brücke (10) verbundenen Stützen (8) und zwei je an einer Stütze (8) angeordneten und die Brücke (10) überragenden Haltefingern (9) gebildet ist, wobei die Brücke (10) als Kabelbaumunterstützung fest angeordnet ist und die Haltefinger (9) in ihrer Längsrichtung an oder in der Stütze (8) verschiebbar und durch Federkraft in die Gebrauchsstellung zurückführbar sind.

2. Kabelbaum-Legevorrichtung nach Anspruch 1, dadurch gekennzeichnet, daß der Haltefinger (9) in die zugehörige, rohrförmige Stütze (8) teleskopisch einschiebbar ist.

## Claims

1. A wiring harness laying device with at least one holder (4) which can be mounted on an installation board (1) and the retaining fingers (9) of which, laterally defining the position of the wiring harness, can be deflected transversely to the longitudinal direction of the wiring harness, characterised in that the holder (4) is formed from at least two supports (8), which are secured to the installation board (1) and which are connected with one another by a bridge (10), and from two retaining fingers (9) each arranged on a support (8) and projecting above the bridge (10), wherein the bridge (10) is arranged securely as a cable harness support and the retaining fingers (9) are displaceable in their longitudinal direction on or in the support (8) and can be returned into the operative position by spring force.

2. A wiring harness laying device according to Claim 1, characterised in that the retaining fingers (9) can be inserted telescopically into the associated tubular support (8).

## Revendications

1. Dispositif de pose de faisceaux de câbles, comprenant au moins un élément de maintien (4) qui peut être fixé sur une planche de pose (1) et dont les doigts de retenue (9), délimitant latéralement la position du faisceau de câbles, peuvent s'effacer perpendiculairement à la direction longitudinale du faisceau de câbles, caractérisé en ce que l'élément de maintien (4) est constitué par au moins deux colonnettes (8) qui sont fixées sur la planche de pose (1) et sont reliées l'un à l'autre par une traverse en pont (10), et par deux doigts retenue (9) qui sont montés chacun sur une colonnette (8) et font saillie au-dessus de la traverse en pont (10), la traverse en pont (10) étant fixée rigidement en tant qu'appui pour le faisceau de câbles et les doigts de retenue (9) étant mobiles dans leur direction longitudinale sur ou dans les colonnettes (8) et pouvant être ramenés dans leur position d'utilisation par la force de ressorts.

2. Dispositif de pose de faisceaux de câbles selon la revendication 1, caractérisé en ce que les doigts de retenue (9) peuvent être insérés télescopiquement dans les colonnettes tubulaires (8) respectives.
